# EUROPEAN PATENT APPLICATION

(11) **EP 4 836 293 A1**
(43) Date of publication of application: **04.11.2026**
(21) Application number: 24911622.9
(22) Date of filing: 30.12.2024
(51) Int. Cl.: H02S 50/00, G01R 31/34, G06N 3/0464, G06N 3/08

(54) **FAULT DIAGNOSIS METHOD AND SYSTEM FOR PHOTOVOLTAIC TRACKING SUPPORT**

(30) Priority: 29.12.2023 CN 202311864370
(71) Applicant: Trina Vanguard Tracker (JiangSu ChangZhou) Co., Ltd., Changzhou City, Jiangsu Province (CN)
(72) Inventor: SUN, Kai, Changzhou, Jiangsu 213031 (CN); JIANG, Zhenlin, Changzhou, Jiangsu 213031 (CN); HUANG, Guokun, Changzhou, Jiangsu 213031 (CN); QUAN, Peng, Changzhou, Jiangsu 213031 (CN); ZHAO, Ming, Changzhou, Jiangsu 213031 (CN); YE, Yizhou, Changzhou, Jiangsu 213031 (CN); CHEN, Yun, Changzhou, Jiangsu 213031 (CN)
(74) Representative: Nederlandsch Octrooibureau
(86) International application number: PCT/CN2024/143832
(87) International publication number: WO 2025/140709

(57) **Abstract**

A fault diagnosis method and system for a photovoltaic tracking support. The method comprises the following steps: in the operation process of a photovoltaic tracking support, tracking control units that correspond to the photovoltaic tracking support continuously acquiring one-dimensional time-domain operating signals of the photovoltaic tracking support; converting the one-dimensional time-domain operating signals into two-dimensional time-frequency-domain operating signals; performing feature extraction on the two-dimensional time-frequency-domain operating signals to obtain an operating feature map; and determining whether the operating feature map is a fault feature map, so as to diagnose whether the photovoltaic tracking support has a fault. The fault diagnosis method and system for a photovoltaic tracking support can improve the stability, accuracy and intelligence level of fault diagnosis for photovoltaic tracking supports.

## Description

### Technical Field

The present application mainly relates to the field of photovoltaic tracking support, and in particular to a fault diagnosis method and system for a photovoltaic tracking support.

### Background

Fault diagnosis of photovoltaic tracking support is an important technology in the field of photovoltaic cells, which can timely detect and diagnose faults in a tracking system, so as to ensure normal system operation and maximize power generation efficiency. Since photovoltaic equipment operates in the external environment for a long time, the support system is susceptible to dust, rain and other interferences, which prevents the photovoltaic tracking support from adjusting its attitude angle accurately. Once a fault occurs, the power generation capacity of the solar photovoltaic system will be affected and the power generation efficiency will be reduced. Most existing operation monitoring for photovoltaic tracking support relies on sensor measurement and analysis algorithms based on sensor data, however, restricted by the operating conditions of photovoltaic system and other factors, the conventional fault diagnosis solutions for photovoltaic tracking support still suffer from various defects, such as low intelligence, insufficient accuracy and delayed fault alerts.

### Summary

The technical problem to be solved by the present application is to provide a fault diagnosis method and system for a photovoltaic tracking support, which can enhance the stability, accuracy and intelligence of fault diagnosis of the photovoltaic tracking support.

In order to solve the above technical problems, the present application provides a fault diagnosis method for a photovoltaic tracking support, characterized by comprising the following steps: in an operation process of the photovoltaic tracking support, a tracking control unit corresponding to the photovoltaic tracking support continuously acquiring one-dimensional time-domain operating signal of the photovoltaic tracking support; converting the one-dimensional time-domain operating signal into a two-dimensional time-frequency domain operating signal; performing feature extraction on the two-dimensional time-frequency domain operating signal to obtain an operating feature map; and determining whether the operating feature map belongs to a fault feature map, so as to diagnose whether the photovoltaic tracking support occurs a fault.

In one embodiment of the present disclosure, the method further comprises extracting information of the one-dimensional time-domain operating signal on time scales by means of a wavelet transform, so as to capture variation characteristics of the one-dimensional time-domain operating signal on different time scales, so as to obtain the two-dimensional time-frequency domain operating signal.

In one embodiment of the present disclosure, the method further comprises obtaining a wavelet transform coefficient through a following formula: ${W}_{φ} \left(a, b\right) = \frac{1}{\sqrt{a}} \int x \left(t\right) φ * \left(\frac{t - b}{a}\right) d t , a , b ∈ R , a \neq 0$ wherein, *φ* is a mother wavelet, *φ** is a complex conjugate mother wavelet, x(t) is an input signal, t is time, *a* is a scaling factor, *b* is a translation factor.

In one embodiment of the present disclosure, the method further comprises: acquiring multiple operating feature maps corresponding to different fault types first, and obtaining a fault type recognition model through training based on a convolutional neural network; and in the operation process of the photovoltaic tracking support, inputting the operating feature maps into the fault type recognition model in real time, and determining whether the operating feature maps belong to fault feature maps according to an output of the fault type recognition model.

In one embodiment of the present disclosure, in the training process, the method further comprises dividing each or multiple operating feature maps into multiple image regions; generating a ${F}_{avg}^{s} ∈ {R}^{1 \times H \times W}$ first feature map by average pooling and generating a ${F}_{max}^{s} ∈ {R}^{1 \times H \times W}$ second feature map by max pooling, wherein: R^{1×H×W} represents an image with a channel number of 1, a height of H and a width of W, F is a feature map input into a network, and a superscript S thereof is used to distinguish feature map subjected to pooling operation; concatenating the first feature map and the second feature map into a two-channel feature map; and generating a spatial attention map through convolution to obtain the fault type recognition model.

In one embodiment of the present disclosure, the one-dimensional time-domain operating signal includes a current signal of a driving motor of the photovoltaic tracking support.

In one embodiment of the present disclosure, the method further comprises determining whether the operating feature maps belong to fault feature maps by adopting the following cross-entropy loss function: ${L}_{softmax} = - {\sum }_{i = 1}^{N} {q}_{i} {log}_{a} \frac{{e}^{{w}_{i}^{T} f}}{{\sum }_{k = 1}^{N} {e}^{{w}_{k}^{T} f}}$ wherein, N is categories number, *wᵢ* is a weight vector of an i category of a fully connected layer, *qᵢ* is a label smoothing factor, *a* is a scaling factor, T stands for transpose, and f is an integration function.

In one embodiment of the present disclosure, the method further comprises comprising calculating the label smoothing factor *qᵢ* by using the following formula: ${q}_{i} = \left\{\begin{matrix}\frac{ε}{N} , y \neq i \\ 1 - \frac{N - 1}{N} ε , y = i\end{matrix}\right.$ wherein, *ε* is a label smoothing parameter, which is configured to reduce a weight of true labels during calculation of the loss function to prevent the model from overfitting training data and improve its generalization capability, y is a one-hot label.

Another aspect of the present disclosure also provides a fault diagnosis system for a photovoltaic tracking support, comprising multiple tracking control units, adapted to continuously acquire one-dimensional time-domain operating signal of the photovoltaic tracking support in an operation process of the photovoltaic tracking support; a data acquisition and monitoring control system, adapted to diagnose whether a fault occurs in the photovoltaic tracking support according to the fault diagnosis method as defined in any embodiments of the present disclosure.

Another aspect of the present disclosure also provides a computer-readable storage medium having a computer program stored thereon, when the computer program is executed by a processor, the steps of the host-vehicle tire identification method based on an antenna as mentioned above are implemented.

Compared with the prior art, the present application has the following advantages: the present application collects signals such as motor current of the tracking support, converts into time-frequency diagrams through wavelet transform for time-frequency analysis, and adopts a deep learning-based image classification algorithm to extract features of time-frequency diagrams corresponding to various fault types for learning and modeling, the constructed model is capable of identifying features of time-frequency diagrams and establishing correlations with corresponding fault types, and can be applied to fault diagnosis of photovoltaic tracking support with higher stability, accuracy and intelligence.

### Brief Description of the Drawings

The drawings are included to provide a further understanding of the present application, and they are included and constitute a part of the present application, the drawings show the embodiments of the present application, and serving to explain the principles of the present application together with the description. In the drawings:
FIG. 1 is a schematic flowchart of a fault diagnosis method for a photovoltaic tracking support according to an embodiment of the present application;
FIG. 2 is a schematic diagram for monitoring one-dimensional time-domain operating signals of multiple photovoltaic tracking supports in the fault diagnosis method for a photovoltaic tracking support according to an embodiment of the present application;
FIG. 3 and FIG. 4 are schematic diagrams illustrating the logical principle of a fault diagnosis method for a photovoltaic tracking support according to an embodiment of the present application;
FIG. 5 - FIG. 7 are fault feature diagrams of different fault types of photovoltaic tracking support adopting the fault diagnosis method for a photovoltaic tracking support according to an embodiment of the present application; and
FIG. 8 is a system block diagram of a fault diagnosis system for a photovoltaic tracking support according to an embodiment of the present application.

### Preferred Embodiment of the Present Disclosure

In order to illustrate the technical solutions in the embodiments of the present application more clearly, the drawings that need to be used in the description of the embodiments will be briefly introduced below. Obviously, the drawings in the following description are only some embodiments of the present application, and for those skilled in the art, other drawings can also be obtained based on these drawings without creative effort.

As indicated in this application and claims, the terms "a", "an", "a kind of" and/or "the" do not specifically refer to the singular and may include the plural unless the context clearly indicates an exception. Generally speaking, the terms "comprising" and "including" only suggest the inclusion of clearly identified steps and elements, and these steps and elements do not constitute an exclusive list, and the method or device may also contain other steps or elements.

The relative arrangements of components and steps, numerical expressions and numerical values set forth in these embodiments do not limit the scope of the present application unless specifically stated otherwise. At the same time, it should be understood that, for the convenience of description, the sizes of the various parts shown in the drawings are not drawn according to the actual proportional relationship. Techniques, methods and devices known to those of ordinary skill in the relevant art may not be discussed in detail, but where appropriate, such techniques, methods and devices should be considered part of the authorized specification. In all embodiments shown and discussed herein, any specific values should be construed as illustrative only, and not as limiting. Therefore, other examples of the exemplary embodiment may have different values. It should be noted that like numerals and letters denote like items in the following figures, therefore, once an item is defined in one figure, it does not require further discussion in subsequent drawings.

In addition, it should be noted that the use of words such as "first" and "second" to define components is only for the convenience of distinguishing corresponding components, unless otherwise stated, the above words have no special meanings, and therefore cannot be construed as limiting the protection scope of the present application. In addition, although the terms used in this application are selected from well-known and commonly used terms, some terms mentioned in the specification of this application may be selected by the applicant according to his or her judgment, and their detailed meanings are listed in this article described in the relevant section of the description. Furthermore, it is required that this application be understood not only by the actual terms used, but also by the meaning implied by each term.

It will be understood that when an element is referred to as being "on," "connected to," "coupled to" or "in contacting with" another element, it can be directly on, connected to, coupled to, or in contact with the other element, or there may be an intervening component. In contrast, when an element is referred to as being "directly on," "directly connected to," "directly coupled to" or "directly in contacting with" another element, there are no intervening elements present. Likewise, when a first component is referred to as being "electrically contacting" or "electrically coupled to" a second component, there exists an electrical path between the first component and the second component that allows electrical current to flow. This electrical path may include capacitors, coupled inductors, and/or other components that allow current to flow, even without direct contact between conductive components.

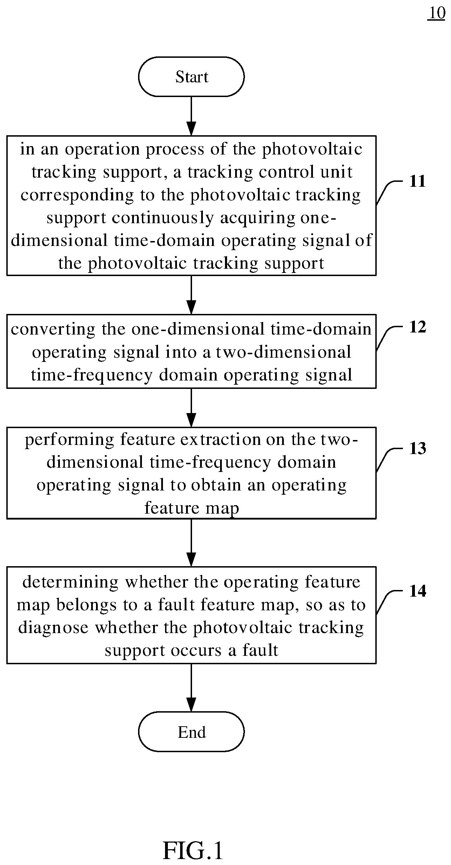

With reference to FIG. 1, the present application proposes a fault diagnosis method 10 for a photovoltaic tracking support (hereinafter referred to as "fault diagnosis method 10"). The fault diagnosis method 10 can improve the stability, accuracy and intelligence of fault diagnosis for photovoltaic tracking support. The flow chart FIG. 1 is used in this application to illustrate the operations performed by the system according to the embodiment of this application. It should be understood that the preceding or following operations are not necessarily performed in an exact order. Instead, various steps may be processed in reverse order or concurrently. At the same time, other operations can either add to these procedures, or a certain step or steps can be removed from these procedures.

With reference to FIG. 1, the fault diagnosis method 10 includes the following steps.

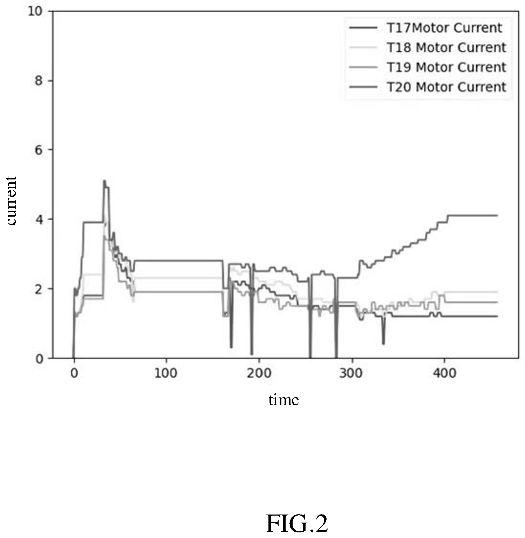

Step 11 is in an operation process of the photovoltaic tracking support, a tracking control unit corresponding to the photovoltaic tracking support continuously acquiring one-dimensional time-domain operating signal of the photovoltaic tracking support. Exemplarily, the one-dimensional time-domain operating signal in step 11 includes current signals of the driving motor of the photovoltaic tracking support. FIG. 2 illustrates current signals corresponding to tracking control units T17, T18, T19 and T20 of several photovoltaic tracking supports collected by the fault diagnosis method 10 in an embodiment of the present application, it can be seen that different tracking control units exhibit varying variation characteristics of one-dimensional time-domain operating signals, and subsequent steps will further process the one-dimensional time-domain operating signal of each tracking control unit.

With further reference to FIG. 1, step 12 is converting the one-dimensional time-domain operating signal into a two-dimensional time-frequency domain operating signal. Further preferably, on the basis of the fault diagnosis method 10 shown in FIG. 1, a preferred embodiment of the present application further proposes extracting information of the one-dimensional time-domain operating signal on time scales by means of a wavelet transform, so as to capture variation characteristics of the one-dimensional time-domain operating signal on different time scales, so as to obtain the two-dimensional time-frequency domain operating signal.

Exemplarily, it can obtain a wavelet transform coefficient through a following formula: ${W}_{φ} \left(a, b\right) = \frac{1}{\sqrt{a}} \int x \left(t\right) φ * \left(\frac{t - b}{a}\right) d t , a , b ∈ R , a \neq 0$ wherein, *φ* is a mother wavelet, *φ** is a complex conjugate mother wavelet, x(t) is an input signal, t is time, *a* is a scaling factor, *b* is a translation factor. A wavelet time-frequency diagram can display information such as time, frequency and energy of a signal through a two-dimensional image, which carries far richer information compared with a conventional one-dimensional signal. Therefore, diagnosis using the two-dimensional time-frequency domain operating signal obtained via wavelet transform can achieve better diagnosis stability and accuracy.

With further reference to FIG. 1, step 13 is performing feature extraction on the two-dimensional time-frequency domain operating signal to obtain an operating feature map. Step 14 is determining whether the operating feature map belongs to a fault feature map, so as to diagnose whether the photovoltaic tracking support occurs a fault.

It can be seen that steps 13 and 14 in the fault diagnosis method 10 shown in FIG. 1 rely on image processing means for the two-dimensional time-frequency domain operating signal. In a preferred implementation solution of the present application based on the fault diagnosis method 10 shown in FIG. 1, the fault type recognition model can be established in the following manner, and the fault diagnosis detection of the operating feature map in step 14 can be completed based on the trained fault type recognition model.

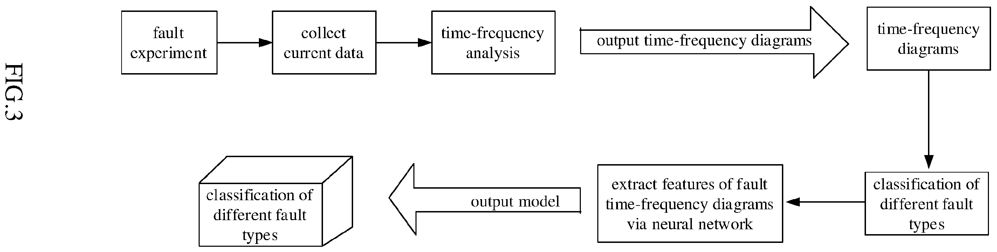

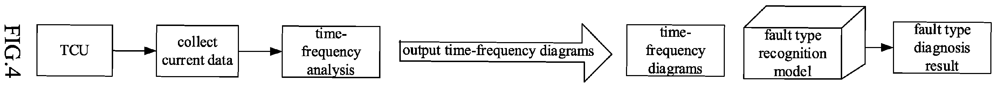

Specifically, in this preferred implementation solution, it needs to acquire multiple operating feature maps corresponding to different fault types first, and to obtain a fault type recognition model through training based on a convolutional neural network. Furthermore, in the operation process of the photovoltaic tracking support, inputting the operating feature map into the fault type recognition model in real time, and determining whether the operating feature maps belong to fault feature maps according to an output of the fault type recognition model. Exemplarily, FIG. 3 and FIG. 4 respectively show schematic diagrams of logical principles for establishing a fault type recognition model and performing detection by using the fault type recognition model. According to FIG. 3, fault experiments are carried out to collect operating current data of motors corresponding to photovoltaic tracking support and perform time-frequency domain analysis, after outputting time-frequency diagrams, conducting image classification for different fault types based on the time-frequency diagrams; further, extracting image features of fault time-frequency diagrams based on a neural network, and finally outputting a fault type recognition model.

Further according to FIG. 4, after obtaining the fault type recognition model, step 11 can be executed in real time during operation of the photovoltaic tracking support, and the one-dimensional time-domain operating signal of the photovoltaic tracking support is continuously acquired by a tracking control unit TCU. It can be understood that the foregoing training of the fault type recognition model mainly adopts current data for training, but the present application is not limited thereto. In some other embodiments of the present application, when the one-dimensional time-domain operating signal to be monitored include other inputs besides current, the fault type recognition model can be pertinently trained according to actual application scenarios, such as structural faults of the support. Other types of fault defects are simultaneously introduced as training inputs on the basis of current inputs, so as to enrich the types of faults detectable by the trained fault type recognition model. Accordingly, when the time-frequency diagrams collected and processed during the actual operation of the photovoltaic tracking support are input into the fault type recognition model, the diagnosis result of the fault type can be directly obtained.

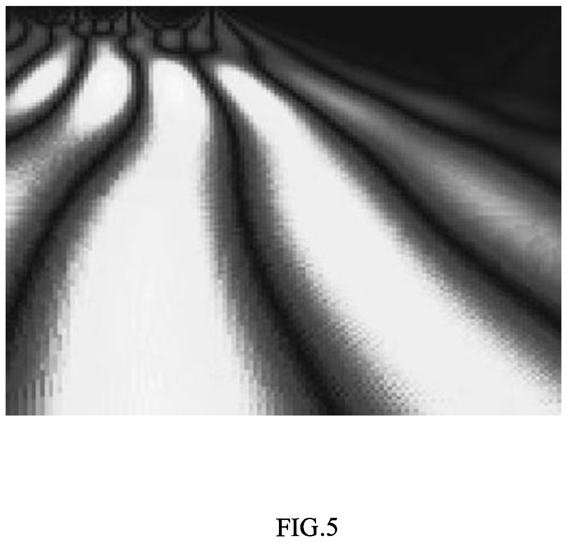

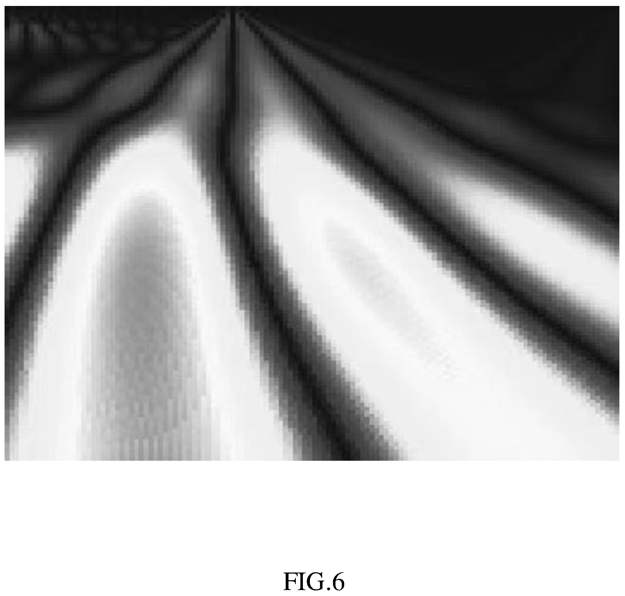

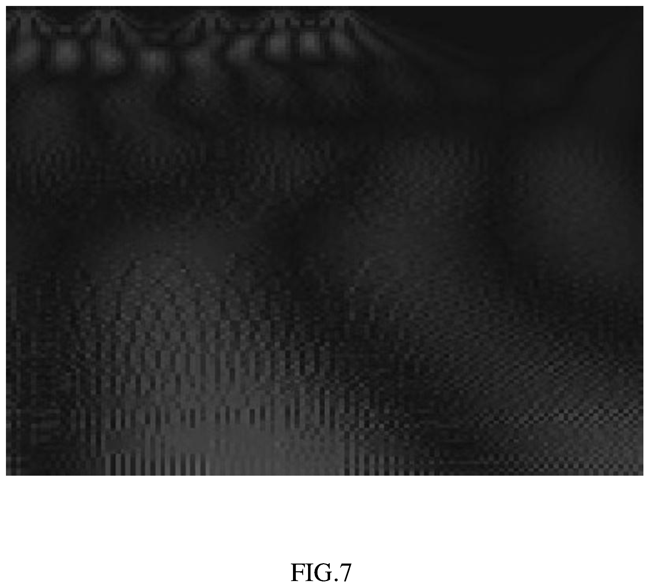

The diagnosis model proposed by the present application based on machine learning and big data analysis achieves excellent detection performance and high intelligence, this approach avoids the drawbacks of the prior art, which mainly relies on regular manual data collection via sensors, and realizes all-weather intelligent data collection and diagnosis, moreover, one single trained model can detect multiple different fault categories with diverse available data inputs for diagnosis, leading to significant improvement of detection accuracy and reliability. Exemplarily, FIG. 5 -FIG. 7 show several different types of faults identifiable by the above fault type recognition model, among them, FIG. 5 is a feature diagram under open-circuit defects, FIG. 6 is a feature diagram with increased current intensity, and FIG. 7 is a feature diagram of high-frequency transient current variations. Naturally, FIG. 5 -FIG. 7 only provide illustrative enumerations, and the present application is not limited thereto.

Further preferably, the above training process further includes dividing each or multiple operating feature maps into multiple image regions; generating a ${F}_{avg}^{s} ∈ {R}^{1 \times H \times W}$ first feature map by average pooling and generating a ${F}_{max}^{s} ∈ {R}^{1 \times H \times W}$ second feature map by max pooling, and concatenating the first feature map and the second feature map into a two-channel feature map. Finally, generating a spatial attention map through convolution to obtain the fault type recognition model. In this preferred embodiment, a channel attention mechanism is proposed to improve the model classification accuracy, and adopt global max pooling and global average pooling to avoid information loss during pooling operations, after that, use multi-layer perceptron splice fully connected layers, and use a Sigmoid activation function for output to obtain a weight matrix of the channel dimension of the feature map, so as to realize extraction of important information in the time-frequency diagram. On this basis, considering that different regions of the feature map exert different effects on feature recognition, spatial attention can assist the model in learning the relationships among feature maps and locating key regions for processing, thereby improving detection accuracy and reliability.

Preferably, in any embodiment of the present application, it further determines whether the operating feature map belongs to fault feature maps by adopting the following cross-entropy loss function: ${L}_{softmax} = - {\sum }_{i = 1}^{N} {q}_{i} {log}_{a} \frac{{e}^{{w}_{i}^{T} f}}{{\sum }_{k = 1}^{N} {e}^{{w}_{k}^{T} f}}$ wherein, N is categories number, *wᵢ* is a weight vector of an i category of a fully connected layer, *qᵢ* is a label smoothing factor, *a* is a scaling factor, T stands for transpose, and f is an integration function. Specifically, when the true category of a sample belongs to a fault in the fault catalog, the integration function f takes a value of 1; otherwise, the integration function f takes a value of 0.

The selection process of the integration function mainly includes detection, isolation and identification steps. The detection step is to judge whether a fault occurs in the system, in the present application, a sample case belongs to the true category if it is judged to be faulty. The identification step is to distinguish the fault types of sample cases with true categories. In some embodiments, it distinguishes fault types by a trained model with a predefined fault catalog. It defines fault categories and corresponding fault features during the model training phase to establish the fault catalog.

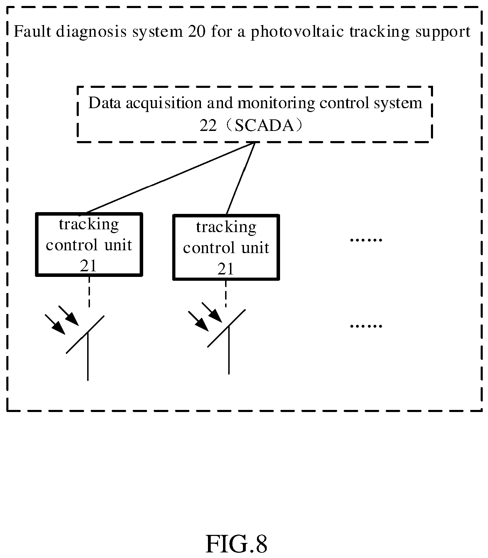

More specifically, it further includes calculating the label smoothing factor *qᵢ* by using the following formula: ${q}_{i} = \left\{\begin{matrix}\frac{ε}{N} , y \neq i \\ 1 - \frac{N - 1}{N} ε , y = i\end{matrix}\right.$ wherein, *ε* is a label smoothing parameter, which is configured to reduce a weight of true labels during calculation of the loss function to prevent the model from overfitting training data and improve its generalization capability, y is a one-hot label. Specifically, y represents the original one-hot label, which is a special label encoding method where only one element of each category has a value of 1, and all other elements have a value of 0. Specifically, for a classification problem with a total of C categories, the one-hot label y of any sample is a vector of length C, in which only one element is 1 to represent the category that the sample belongs to, and all other elements are 0. In another aspect of the present application and with reference to FIG. 8, it further provides a fault diagnosis system 20 for a photovoltaic tracking support, comprising:
multiple tracking control units 21, adapted to continuously acquire one-dimensional time-domain operating signal of the photovoltaic tracking support in an operation process of the photovoltaic tracking support;
a data acquisition and monitoring control system 22, adapted to diagnose whether a fault occurs in the photovoltaic tracking support according to the fault diagnosis method as defined above. Exemplarily, the data acquisition and monitoring control system 22 may directly adopt SCADA in the existing photovoltaic tracking support operation system, that is, the fault diagnosis method proposed above in the present application can be directly deployed in SCADA, accordingly, the diagnosis mode of the photovoltaic tracking support can be conveniently improved without introducing additional hardware costs.

Another aspect of the present disclosure also provides a computer-readable storage medium having a computer program stored thereon, when the computer program is executed by a processor, the steps of the host-vehicle tire identification method based on an antenna as mentioned above are implemented.

The present disclosure proposes a fault diagnosis algorithm for photovoltaic tracking support based on wavelet transform and attention mechanism. Adopting wavelet transform to map the one-dimensional time-domain signal of the motor current signal collected by the TCU into a two-dimensional time-frequency domain. Use convolutional neural network to extract features from the transformed two-dimensional time-frequency diagrams, and the feature maps are then input into a residual network to identify differences among various fault modes, and save the trained network as a model for subsequent fault diagnosis tasks.

The basic concepts have been described above, obviously, for those skilled in the art, the above disclosure of the disclosure is only an example, and does not constitute a limitation to the present application. Although not expressly stated here, various modifications, improvements and amendments to this application may be made by those skilled in the art. Such modifications, improvements, and amendments are suggested in this application, so such modifications, improvements, and amendments still belong to the spirit and scope of the exemplary embodiments of this application.

Meanwhile, the present application uses specific words to describe the embodiments of the present application. For example, "one embodiment", "an embodiment", and/or "some embodiments" refer to a certain feature, structure or characteristic related to at least one embodiment of the present application. Therefore, it should be emphasized and noted that two or more references to "one embodiment" or "an embodiment" or "an alternative embodiment" in different places in this specification do not necessarily refer to the same embodiment. In addition, certain features, structures or characteristics of one or more embodiments of the present application may be properly combined.

Some aspects of the present application may be entirely implemented by hardware, may be entirely implemented by software (including firmware, resident software, microcode, etc.), or may be implemented by a combination of hardware and software. The above hardware or software may be referred to as "block", "module", "engine", "unit", "component" or "system". The processor can be one or more Application Specific Integrated Circuits (ASIC), Digital Signal Processors (DSPs), Digital Signal Processing Devices (DAPDs), Programmable Logic Devices (PLDs), Field Programmable Gate Arrays (FPGAs), a processor, a controller, a microcontroller, a microprocessor, or a combination thereof. Additionally, aspects of the present application may be embodied as a computer product comprising computer readable program code on one or more computer readable media. For example, computer-readable media may include, but are not limited to, magnetic storage devices (e.g., hard disks, floppy disks, magnetic tape...), optical disks (e.g., compact disk CDs, digital versatile disks DVD...), smart cards, and flash memory devices (e.g., cards, sticks, key drives...).

A computer readable medium may contain a propagated data signal embodying a computer program code, for example, in baseband or as part of a carrier wave. The propagated signal may take many forms, including electromagnetic, optical, etc., or a suitable combination. The computer readable medium can be any computer readable medium other than computer readable storage medium, which can communicate, propagate or transfer the program for use by being connected to an instruction execution system, apparatus or device. Program code on a computer readable medium may be transmitted over any suitable medium, including radio, electrical cables, fiber optic cables, radio frequency signals, or the like, or combinations of any of the foregoing.

In the same way, it should be noted that in order to simplify the expression disclosed in the present application and help the understanding of one or more embodiments of the disclosure, in the foregoing description of the embodiments of the present application, sometimes multiple features are combined into one embodiment, drawings or descriptions thereof. However, this method of disclosure does not imply that the subject matter of the application requires more features than are recited in the claims. Indeed, embodiment features are less than all features of a single foregoing disclosed embodiment.

In some embodiments, numbers describing the quantity of components and attributes are used, it should be understood that such numbers used in the description of the embodiments use the modifiers "about", "approximately" or "substantially" in some examples. Unless otherwise stated, "about", "approximately" or "substantially" indicates that the stated figure allows for a variation of ±20%. Accordingly, in some embodiments, the numerical parameters used in the specification and claims are approximations that can vary depending upon the desired characteristics of individual embodiments. In some embodiments, numerical parameters should take into account the specified significant digits and adopt the general digit reservation method. Although the numerical ranges and parameters used in some embodiments of the present application to confirm the breadth of the scope are approximate values, in specific embodiments, such numerical values are set as precisely as practicable.

Although the present application has been described with reference to the current specific embodiments, those of ordinary skill in the art should recognize that the above embodiments are only used to illustrate the present application, and various equivalent changes or substitutions can also be made without departing from the spirit of the present application, therefore, as long as the changes and modifications to the above-mentioned embodiments are within the spirit of the present application, they will all fall within the scope of the claims of the present application.

## Claims

1. A fault diagnosis method for a photovoltaic tracking support, **characterized by** comprising the following steps:
in an operation process of the photovoltaic tracking support, a tracking control unit corresponding to the photovoltaic tracking support continuously acquiring one-dimensional time-domain operating signal of the photovoltaic tracking support;
converting the one-dimensional time-domain operating signal into a two-dimensional time-frequency domain operating signal;
performing feature extraction on the two-dimensional time-frequency domain operating signal to obtain an operating feature map; and
determining whether the operating feature map belongs to a fault feature map, so as to diagnose whether the photovoltaic tracking support occurs a fault.

2. The fault diagnosis method according to claim 1, **characterized by** further comprising extracting information of the one-dimensional time-domain operating signal on time scales by means of a wavelet transform, so as to capture variation characteristics of the one-dimensional time-domain operating signal on different time scales, so as to obtain the two-dimensional time-frequency domain operating signal.

3. The fault diagnosis method according to claim 2, **characterized by** further comprising obtaining a wavelet transform coefficient *W_{φ}*(*a, b*) through a following formula: ${W}_{φ} \left(a, b\right) = \frac{1}{\sqrt{a}} \int x \left(t\right) φ * \left(\frac{t - b}{a}\right) d t , a , b ∈ R , a \neq 0$ wherein, *φ* is a mother wavelet, *φ** is a complex conjugate mother wavelet, x(t) is an input signal, t is time, *a* is a scaling factor, *b* is a translation factor.

4. The fault diagnosis method according to claim 1, **characterized by** further comprising:
acquiring multiple operating feature maps corresponding to different fault types first, and obtaining a fault type recognition model through training based on a convolutional neural network; and
in the operation process of the photovoltaic tracking support, inputting the operating feature maps into the fault type recognition model in real time, and determining whether the operating feature maps belong to fault feature maps according to an output of the fault type recognition model.

5. The fault diagnosis method according to claim 4, **characterized by** further comprising, in the training process:
dividing each or multiple operating feature maps into multiple image regions;
generating a ${F}_{avg}^{s} ∈ {R}^{1 \times H \times W}$ first feature map by average pooling and generating a ${F}_{max}^{s} ∈ {R}^{1 \times H \times W}$ second feature map by max pooling, wherein: R^{1×H×W} represents an image with a channel number of 1, a height of H and a width of W, F is a feature map input into a network, and a superscript S thereof is used to distinguish feature map subjected to pooling operation;
concatenating the first feature map and the second feature map into a two-channel feature map; and
generating a spatial attention map through convolution to obtain the fault type recognition model.

6. The fault diagnosis method according to claim 1, **characterized in that**, the one-dimensional time-domain operating signal includes a current signal of a driving motor of the photovoltaic tracking support.

7. The fault diagnosis method according to any one of claims 1 - 6, **characterized by** further comprising determining whether the operating feature maps belong to fault feature maps by adopting the following cross-entropy loss function: ${L}_{softmax} = - {\sum }_{i = 1}^{N} {q}_{i} {log}_{a} \frac{{e}^{{w}_{i}^{T} f}}{{\sum }_{k = 1}^{N} {e}^{{w}_{k}^{T} f}}$ wherein, N is categories number, *wᵢ* is a weight vector of an i category of a fully connected layer, *qᵢ* is a label smoothing factor, *a* is a scaling factor, T stands for transpose, and f is an integration function.

8. The fault diagnosis method according to claim 7, **characterized by** comprising calculating the label smoothing factor *qᵢ* by using the following formula: ${q}_{i} = \left\{\begin{matrix}\frac{ε}{N} , y \neq i \\ 1 - \frac{N - 1}{N} ε , y = i\end{matrix}\right.$ wherein, *ε* is a label smoothing parameter, which is configured to reduce a weight of true labels during calculation of the loss function to prevent the model from overfitting training data and improve its generalization capability, y is a one-hot label.

9. A fault diagnosis system for a photovoltaic tracking support, comprising:
multiple tracking control units, adapted to continuously acquire one-dimensional time-domain operating signal of the photovoltaic tracking support in an operation process of the photovoltaic tracking support;
a data acquisition and monitoring control system, adapted to diagnose whether a fault occurs in the photovoltaic tracking support according to the fault diagnosis method as defined in any one of claims 1 - 8.

10. A computer-readable storage medium having a computer program stored thereon, **characterized in that**, when the computer program is executed by a processor, the steps of the host-vehicle tire identification method based on an antenna as claimed in any one of claims 1 - 8 are implemented.
